# EUROPEAN PATENT APPLICATION

(11) **EP 3 940 753 A1**
(43) Date of publication of application: **19.01.2022**
(21) Application number: 20185877.6
(22) Date of filing: 15.07.2020
(51) Int. Cl.: H01L 21/336, H01L 29/786

(54) **METHOD FOR PROCESSING A FET DEVICE**

(71) Applicant: Imec VZW, 3001 Leuven (BE)
(72) Inventor: Rassoul, NouredineRassoul, 3001 Leuven (BE); Delhougne, Romain, 3001 Leuven (BE); Belmonte, Attilio, 3001 Leuven (BE); Kar, Gouri Sankar, 3001 Leuven (BE)
(74) Representative: Roth, Sebastian

(57) **Abstract**

The invention relates to a method for processing a FET device, wherein the method comprises:
- providing a substrate (11);
- forming an oxygen passing layer (15) on the substrate (11);
- forming an oxygen blocking layer (13) on the substrate (11), wherein the oxygen blocking layer (13) is arranged next to the oxygen passing layer (15) and delimits the oxygen passing layer (15) on two opposite sides;
- forming an oxide semiconductor layer (17) on the oxygen passing layer (15) and the oxygen blocking layer (13);
- forming a gate structure (19) on the oxide semiconductor layer (17) in a region above the oxygen passing layer (15); and
- modifying a doping of the oxide semiconductor layer (17) by introducing oxygen into the oxygen passing layer (15), wherein at least a portion of the introduced oxygen passes through the oxygen passing layer (15) and into the oxide semiconductor layer (17).

## Description

### TECHNICAL FIELD OF THE INVENTION

The present disclosure relates to a method for processing a FET device and to a structure for a FET device.

### BACKGROUND OF THE INVENTION

Field effect transistors (FETs) are key electronic components in various electronic devices. Generally, a FET comprises a channel that is arranged between a source and a drain contact, as well as a gate contact that is arranged in close proximity to the channel. An electric field is applied to the gate contact to control a current flow through the channel. Thin-film-transistors (TFTs) are special types of FETs that are made by depositing thin films, usually semiconductor layers, dielectric layers and metallic contacts, on non-conducting substrates.

Many modern applications, such as high-density memories, display-on-glass devices, or smart nano-interconnects, comprise such FETs. These devices often operate on a limited power budget and, thus, require a better managing of electric power at the circuit and the FET level.

Oxide semiconductor materials may be used for the channel layer of a FET. Indium gallium zinc oxide (InGaZnO, or short: IGZO) is an oxide semiconductor material that provides several advantages, especially compared to doped amorphous silicon, when used as a channel layer. These advantages are, amongst others, an ultra-low off-state leakage current and a high electron mobility. Further, IGZO allows processing with a low thermal budget, i.e. at low temperatures, enabling a sequential integration with conventional silicon-based transistors. There are two main doping mechanisms for amorphous IGZO (a-IGZO): Off stoichiometry of oxygen ions and incorporation of hydrogen. For the first defect family, oxygen vacancies act as n-type dopants and form shallow donor levels in the IGZO bandgap. Regarding the role of hydrogen, the lead model is linked to the break of weakly-bonded oxygen atoms like in Zn-O by H and forming -OH ions.

However, it is difficult to control the electrical properties of a channel layer of a FET and to avoid damage to the layer during the FET fabrication. In particular, it is difficult to control the concentration of oxygen vacancies in an IGZO channel, especially because hydrogen-based chemistries are commonly used in deposition and patterning steps of a FET fabrication process subsequent to the formation the IGZO channel.

Moreover, because the channel of a FET, in particular of a TFT, is generally covered by other structures, such as a metal gate or a top gate insulator, it is difficult to repair a damaged channel layer, e.g. to recover generated defects in the layer, following the deposition of these other layers.

### SUMMARY OF THE INVENTION

Thus, it is an objective to provide an improved method for processing a FET device, and to provide an improved structure for a FET device. In particular, the above-mentioned disadvantages should be avoided.

The objective is achieved by the embodiments provided in the enclosed independent claims. Advantageous implementations of the embodiments of the invention are further defined in the dependent claims.

According to a first aspect, the present disclosure relates to a method for processing a field effect transistor (FET) device, wherein the method comprises:
- providing a substrate;
- forming an oxygen passing layer on the substrate;
- forming an oxygen blocking layer on the substrate, wherein the oxygen blocking layer is arranged next to the oxygen passing layer and delimits the oxygen passing layer on two opposite sides;
- forming an oxide semiconductor layer on the oxygen passing layer and the oxygen blocking layer;
- forming a gate structure on the oxide semiconductor layer in a region above the oxygen passing layer; and
- modifying a doping of the oxide semiconductor layer by introducing oxygen into the oxygen passing layer, wherein at least a portion of the introduced oxygen passes through the oxygen passing layer and into the oxide semiconductor layer.

This achieves the advantage that a method for processing a FET device is provided which allows to efficiently control the electrical properties of the FET, especially its oxide semiconductor channel layer. In particular, damages or defects in the channel layer that are, for instance, introduced during fabrication of the device and that change the doping of said layer in an unwanted way can be removed, and a desired concentration of oxygen dopants in the layer can be recovered. Preferably, this repair of the oxide semiconductor channel layer can be carried out after depositing other layers or structures, such as the gate structure or a top gate isolator, on top of the oxide semiconductor layer.

Preferably, the oxygen blocking layer confines the sections of the oxide semiconductor layer to which the oxygen is introduced. This can prevent that the oxygen degrades contact resistances between the oxide semiconductor layer and other structures of the FET device, in particular source and drain structures.

The substrate can be a glass or a silicon substrate. Preferably, the substrate is a wafer.

The gate structure can comprise a gate dielectric layer that is formed above the oxide semiconductor layer. Several top gate dielectric materials, thicknesses and crystallinities can be used. Possible top gate materials are aluminum oxide (Al2O₃), hafnium dioxide (HfO₂), or wide band gap oxide semiconductors, such as gallium zinc oxide (GZO) or silicon dioxide (SiO₂). The gate structure can further comprise an electric contact.

Optionally, a bottom gate can be formed on the substrate prior to forming the oxygen passing and the oxygen blocking layer. If such a bottom gate is formed on the substrate, the oxygen passing layer can act as a bottom gate dielectric of the FET device. The bottom gate can be formed as a uniform material layer below the oxygen passing and the oxygen blocking layer, or it can be confined to a region below the oxygen passing layer. If the bottom gate is formed, the gate structure on the oxide semiconductor layer can be partially omitted, in particular only a gate oxide of the gate structure is formed as a protective layer.

Preferably, the FET device is a metal-oxide-semiconductor field-effect transistor (MOSFET). The FET device can be a planar transistor, in particular a thin-film transistor (TFT), or another type of transistor, such as a FinFET.

In an embodiment, the method further comprises the steps of:
- forming a source structure on the oxide semiconductor layer in a region above the oxygen blocking layer on one of the two opposite sides of the oxygen blocking layer; and
- forming a drain structure on the oxide semiconductor layer in a region above the oxygen blocking layer on the other one of the two opposite sides of the oxygen blocking layer.

This achieves the advantage that the oxygen blocking layer below the source and drain structures prevents a degradation of a contact resistance between the oxide semiconductor layer and the source and drain structures. Such a degradation could be caused by the introduced oxygen.

In an embodiment, at least the portion of the oxide semiconductor layer that is arranged between the oxygen passing layer and the gate structure forms a channel of the FET device.

This achieves the advantage that a channel of the FET device with well controlled electrical properties, in particular conductivity, can be provided.

Preferably, the oxide semiconductor layer forming the channel is made from a metal oxide semiconductor material.

In an embodiment, the doping of the oxide semiconductor layer is modified in a section above the oxygen passing layer, wherein the section is essentially congruent with the oxygen passing layer or wherein the section extends beyond the oxygen passing layer.

This achieves the advantage that the section of the oxide semiconductor layer where the doping is modified can be defined by the size of the oxygen passing layer.

In an embodiment, the oxygen is introduced into the oxygen passing layer by means of oxygen annealing, in particular after forming the gate structure.

This achieves the advantage that the oxygen can be introduced in the oxygen passing lay in a simple and efficient way.

In particular, the oxygen annealing and, thus, the recovery of the oxide semiconductor layer can be performed at any stage of the full process flow, in particular at the end of the process flow.

In an embodiment, a portion of the oxygen passing layer is not covered by the gate structure.

This achieves the advantage that the oxygen can efficiently be introduced into the oxygen passing layer, after forming the gate structure on top of the oxide semiconductor layer. For example, the oxygen can penetrate the oxygen passing in the portion that is not covered, i.e. exposed, and, then, distribute evenly throughout the oxygen passing layer and penetrate evenly into the oxide semiconductor layer above the passing layer.

Preferably, the portion of the oxygen passing layer is also not covered by a top gate isolator of the gate structure. More preferably, the oxygen passing layer remains exposed after forming the FET device.

In an embodiment, the oxide semiconductor layer comprises any one of the following materials: indium gallium zinc oxide, IGZO, indium tin oxide, ITO, or indium zinc oxide, IZO.

In an embodiment, the oxygen passing layer comprises a silicon oxide layer, a silicon oxynitride layer, a porous material layer, and/or an air gap.

The air gap can be a gap between the oxide semiconductor layer and the substrate.

In an embodiment, the oxygen blocking layer comprises a metallic and/or a dielectric material, for example tungsten nitride, silicon nitride, aluminum oxide, titanium, titanium nitride, ruthenium, hafnium dioxide, molybdenum, titanium tungsten, silver, gold, or silicon carbonitride.

A FET device processed with the method of the first aspect shows clear "fingerprints" of that method. For example, the oxygen passing and blocking layers are arranged below the channel and the source and drain structures of the FET device. In case the oxygen passing layer comprises a portion that is not covered by the gate structure, then this portion is also visible in the processed FET device.

According to a second aspect, the present disclosure relates to a structure for a FET device, wherein the structure comprises:
- a substrate;
- an oxygen passing layer arranged on the substrate;
- an oxygen blocking layer arranged on the substrate, wherein the oxygen blocking layer is arranged next to the oxygen passing layer and delimits the oxygen passing layer on two opposite sides;
- an oxide semiconductor layer arranged on the oxygen passing layer and the oxygen blocking layer; and
- a gate structure arranged on the oxide semiconductor layer in a region above the oxygen passing layer;
- wherein the oxide semiconductor layer comprises a doping, wherein the doping, in particular a concentration of dopants, is modified in a section above the oxygen passing layer.

This achieves the advantage that a structure for a FET device is provided whose electrical properties, especially the electrical properties of its oxide semiconductor channel layer, can efficiently be controlled. In particular, damages or defects in the oxide semiconductor layer that are, for instance, introduced during fabrication of the structure and that change the doping of said layer in an unwanted way can be removed, and a desired concentration of oxygen dopants in the layer can be recovered. Preferably, this repair of the oxide semiconductor layer can be carried out after depositing other layers or structures, such as the gate structure, on top of the oxide semiconductor layer.

Preferably, the oxygen blocking layer prevents that the oxygen that is introduced in the oxygen passing layer degrades a contact resistance between the oxide semiconductor layer and other structures of the FET device, in particular source and drain metal contacts.

The structure can form a portion or section of the FET device or can form the entire FET device. Preferably, the FET device is a metal-oxide-semiconductor field-effect transistor (MOSFET). The FET device can be a planar transistor, in particular a thin-film transistor (TFT), or another type of transistor, such as a FinFET.

The structure can be integrated in an electric device, such as a display, a memory, a data processing unit, or an interconnect.

In an embodiment, the structure further comprises:
- a source structure arranged on the oxide semiconductor layer in a region above the oxygen blocking layer on one of the two opposite sides of the oxygen blocking layer; and
- a drain structure arranged on the oxide semiconductor layer in a region above the oxygen blocking layer on the other one of the two opposite sides of the oxygen blocking layer.

This achieves the advantage that the oxygen blocking layer below the source and drain structures prevents a degradation of a contact resistance between the oxide semiconductor layer and the source and drain structures. Such a degradation could be caused by the introduced oxygen.

In an embodiment, at least the portion of the oxide semiconductor layer that is arranged between the oxygen passing layer and the gate structure forms a channel of the FET device.

This achieves the advantage that a channel of the FET device with well controlled electrical properties, in particular conductivity and contact resistance to source/drain, can be provided.

In an embodiment, the section in which the doping is modified is congruent with the oxygen passing layer or the section extends beyond the oxygen passing layer.

This achieves the advantage that the section of the oxide semiconductor layer where the doping is modified can be defined by the size of the oxygen passing layer.

In an embodiment, the oxide semiconductor layer comprises any one of the following materials: indium gallium zinc oxide, IGZO, indium tin oxide, ITO, or indium zinc oxide, IZO.

In an embodiment, the oxygen passing layer comprises a silicon oxide layer, a silicon oxynitride layer, a porous material layer, and/or an air gap.

In an embodiment, the oxygen blocking layer comprises a metallic and/or a dielectric material, for example tungsten nitride, silicon nitride, aluminum oxide, titanium, titanium nitride, ruthenium, hafnium dioxide, molybdenum, titanium tungsten, silver, gold, or silicon carbonitride.

The above description with regard to the method for processing the FET device according to the first aspect of the present disclosure is correspondingly valid for the structure for the FET device according to the second aspect of the present disclosure.

### BRIEF DESCRIPTION OF THE DRAWINGS

The invention will be explained in the followings together with the figures.
- Figs. 1a-d: show steps of a method for processing a FET device according to an embodiment;
- Figs. 2a-d: show steps of a method for forming an oxygen passing layer and an oxygen blocking layer according to an embodiment;
- Figs. 3a-d: show steps of an alternative method for forming an oxygen passing layer and an oxygen blocking layer according to an embodiment;
- Fig. 4: shows a cross-sectional view of a structure for an FET device according to an embodiment;
- Fig. 5a-b: show a perspective view and a top view of a structure for an FET device according to further embodiments; and
- Fig. 6a-b: show cross section views of structures for an FET device according to further embodiments.

### DETAILED DESCRIPTION OF THE PREFERRED EMBODIMENTS

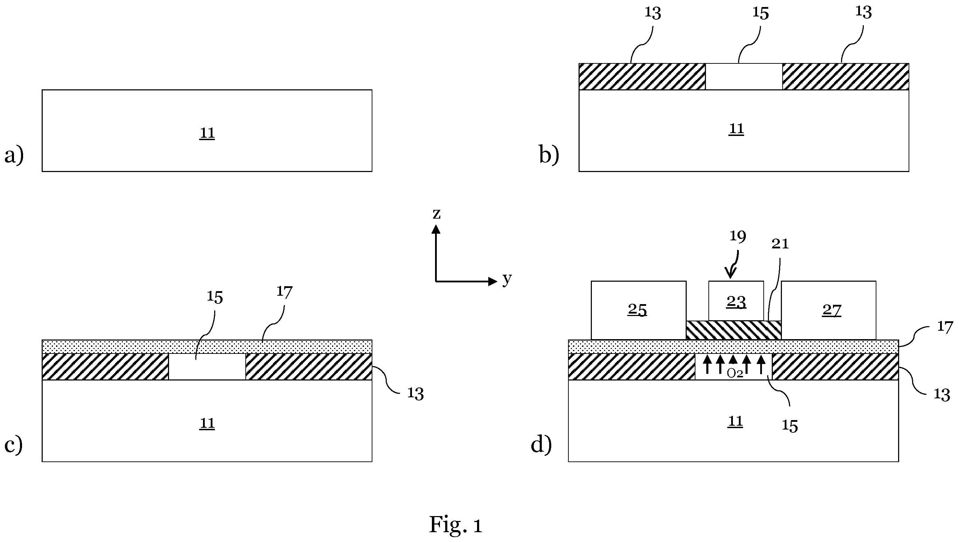

Figs. 1a-d show steps of a method for processing a FET device according to an embodiment.

Thereby, Figs. 1a-d show the processing of a single FET device. Nevertheless, the method may be used to process a plurality of FET devices in parallel, in particular on the same substrate 11.

The method comprises, as shown in FIG. 1a, providing a substrate 11. The substrate 11 can be a glass or a silicon wafer. In particular, the substrate 11 is a wafer, e.g. a 300 mm wafer.

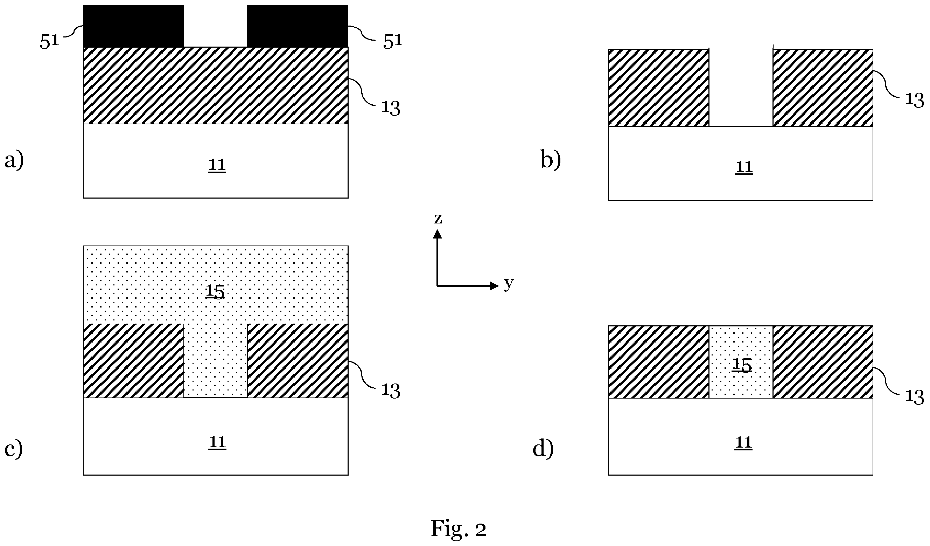

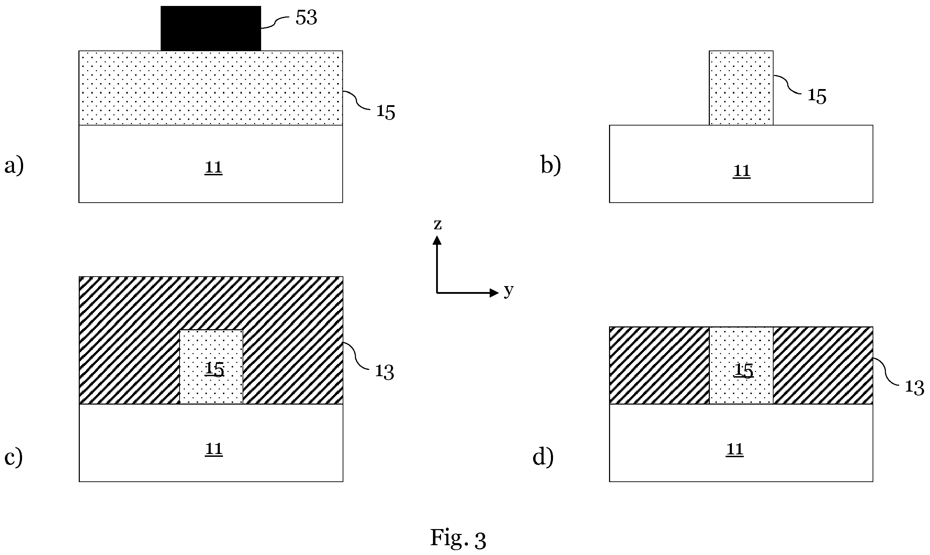

As shown in Fig. 1b, the method comprises forming an oxygen passing layer 15 and an oxygen blocking layer 13 on the substrate 11. The oxygen blocking layer 13 is arranged next to the oxygen passing layer 15 and delimits the oxygen passing layer 15 on two opposite sides. Two alternative methods for forming the oxygen passing layer 15 and the oxygen blocking layer 13 on the substrate 11 are shown in Figs. 2a-d and Figs. 3a-d and are discussed below.

Preferably, the oxygen passing layer 15 is a silicon oxide layer, in particular a silicon dioxide layer. Alternatively, the oxygen passing layer 15 can be a porous material layer, e.g. a material having pores through which oxygen can propagate. The oxygen passing layer 15 can also form an air gap delimited by the oxygen blocking layer 13.

The oxygen blocking layer 13 can be made of a metallic and/or a dielectric material, for example tungsten nitride, silicon nitride, aluminum oxide, titanium, titanium nitride, ruthenium, or hafnium dioxide.

The oxygen passing layer 15 and/or the oxygen blocking layer 13 can be deposited on the substrate 11 by means of a suitable deposition process, e.g. chemical vapor deposition.

Optionally, a bottom gate can be formed on the substrate 11 prior to forming the oxygen passing layer 15 and the oxygen blocking layer 13. If such a bottom gate is formed on the substrate, the oxygen passing layer 15 can act as a bottom gate dielectric of the FET device. The bottom gate can be formed as a uniform material layer below the oxygen passing layer 15 and the oxygen blocking layer 13, or it can be confined to a region below the oxygen passing layer 15.

In a subsequent step, shown in Fig 1c, an oxide semiconductor layer 17 is formed on the oxygen passing layer 15 and the oxygen blocking layer 13.

The oxide semiconductor layer 17 can form a channel of the FET device. The oxide semiconductor layer 17 can be made from a metal oxide semiconductor material. In particular, the oxide semiconductor layer 17 is made from one of the following materials: indium gallium zin oxide (IGZO), indium tin oxide (ITO), or indium zinc oxide (IZO).

In particular, the oxygen passing layer 15 forms an oxygen canal below the oxide semiconductor layer 17 through which oxygen (O₂) can diffuse.

As shown in Fig id, the method further comprises forming a gate structure 19 on the oxide semiconductor layer 17 in a region above the oxygen passing layer 15. For example, the gate structure 19 comprises a gate oxide 21 and a gate metal contact 23. The gate oxide can be made of aluminum oxide (Al₂O₃).

The method may further comprise forming a source structure 25 and a drain structure 27 on the oxide semiconductor layer 17 in regions above the oxygen blocking layer 13. In particular, the source and drain structures 25, 27 are formed on two opposite sides of the oxygen blocking layer. The oxide semiconductor layer 17 above the oxygen passing layer can then form a FET channel between source and drain structures 25, 27.

However, several processing steps, for instance the formation of the source and drain structures 25, 27 can lead to damages and an unwanted doping (or change of a doping) of the oxide semiconductor layer 17. This unwanted doping can be caused by the formation of additional oxygen vacancies in the oxide semiconductor layer 17.

To recover the oxide semiconductor layer 17, oxygen is introduced into the oxygen passing layer 15, wherein at least a portion of the introduced oxygen passes through the oxygen passing layer 15 and into the oxide semiconductor layer 17 (indicated by arrows in Fig. id). Thereby, the doping of the oxide semiconductor layer 17 is modified, in particular by filling up the unwanted oxygen vacancies. In this context, modifying a doping of the oxide semiconductor layer 17 may refer to removing an unwanted doping from the layer 17 or restoring an initial doping of the layer 17, so that desired electrical properties of the layer 17 are restored.

The doping of the oxide semiconductor layer 17 can be modified in a section above the oxygen passing layer by the introduced oxygen atoms. Preferably, the section is congruent with the oxygen passing layer or extends to a certain extend beyond the oxygen passing layer. In particular, the oxygen atoms can diffuse for short distances within the oxide semiconductor layer 17, which may cause the size of the "modified" section to be larger, in particular wider, than the oxygen passing layer 15 below. This effect can be taken into account when forming these layers 15, 17, such that "modified" section of the oxide semiconductor layer 17 corresponds to the channel of the FET device.

At the same time, the oxygen blocking layer 13 below the source and drain structures 25, 27 prevents a degradation of the contact and/or access resistance of the metal oxide semiconductor layer 17 to the source and drain structures 25, 27.

Preferably, the oxygen is introduced into the oxygen passing layer 15 by means of oxygen annealing. The oxygen annealing can take place after forming the gate structure 19 and/or a top gate insolation layer on top of the oxide semiconductor layer 17.

Preferably, a portion of the oxygen passing layer 15 is not covered by the gate structure 19. The oxygen passing layer 15 can extend along an x-direction, perpendicular to the cross-sectional view in y-z-direction as indicated by the schematic coordinate system in Figs. 1a-d. The portion of the oxygen passing layer 15 that is not covered by the gate structure 19 can be located in front or behind the gate structure 19 in x-direction. This uncovered or exposed portion of the oxygen passing layer 15 improves the intake of oxygen atoms, e.g. during oxygen annealing, in the oxygen passing layer 15, in particular because the metal gate or a top gate insulator can act as blocking layers for the oxygen. Once the oxygen atoms have entered the oxygen passing layer 15, they can spread through said layer 15 and into the oxide semiconductor layer 17 to realize a complete and uniform recovery in the section above the passing layer 15.

Figs. 2a-d show steps of a method for forming the oxygen passing layer 15 and the oxygen blocking layer 13 on the substrate 11 according to an embodiment.

The method comprises, as shown in Fig. 2a, forming the oxygen blocking layer 13 as uniform coating on the substrate 11 and forming a masking structure 51 on top of the oxygen blocking layer 13.

In a subsequent step, shown in Fig 2b, the oxygen blocking layer 13 is selective removed below an opening of the masking structure 51, e.g. by means of dry or wet etching. Afterwards, as shown in Fig. 2c, the oxygen passing layer 15 material is deposited on top of the structured oxygen blocking layer 13, especially into the recesses that was formed during the prior selective removal step.

In a final step, shown in Fig. 2d, excess material of the oxygen passing layer 15 is removed, e.g. by grinding or etching, such that the oxygen passing layer 15 is confined to a recesses of the structured oxygen blocking layer 13.

Figs. 3a-d show steps of an alternative method for forming the oxygen passing layer 15 and the oxygen blocking layer 13 on the substrate 11 according to an embodiment.

The alternative method starts with forming the oxygen passing layer 15 as a uniform coating on the substrate 11, as shown in Fig. 3a. A masking structure 53 is formed on top of the oxygen passing layer 15. Subsequently, as shown in Fig. 3b, the oxygen passing layer 15 is selective removed below openings of the masking structure 53.

Afterwards, as shown in Fig. 3c, the oxygen blocking layer 13 material is deposited on top of the structured oxygen passing layer 15 and on the substrate 11 where the oxygen passing layer 15 was removed. In a final step, shown in Fig. 3d, excess material of the oxygen blocking layer 13 is removed, e.g. by grinding or etching.

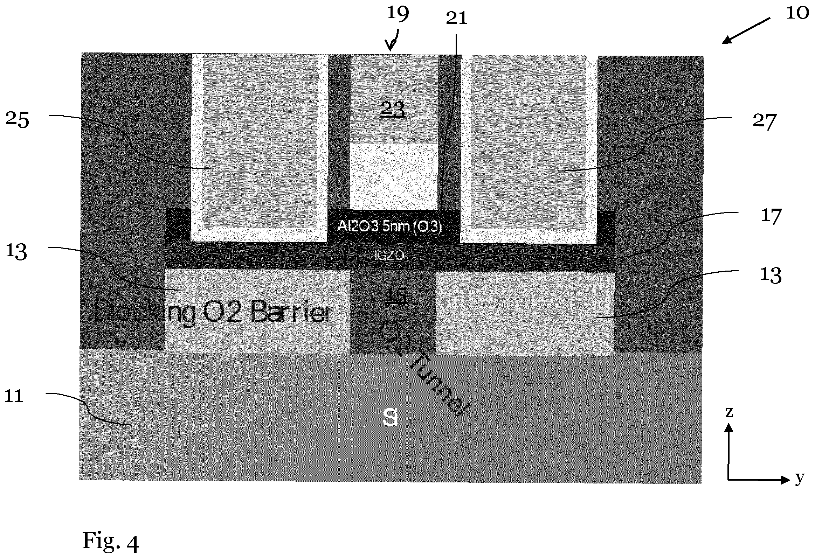

Fig. 4 shows a cross-sectional view of a structure 10 for the FET device according to an embodiment. In particular, the structure 10 shown in Fig. 4 was processed by the method as shown in Figs. 1a-d.

The structure 10 comprises the substrate 11, the oxygen passing layer 15 arranged on the substrate 11, and the oxygen blocking layer 13 arranged on the substrate 11, wherein the oxygen blocking layer 13 is arranged next to the oxygen passing layer 15 and delimits the oxygen passing layer 15 on two opposite sides. The structure 10 further comprises the oxide semiconductor layer 17 arranged on the oxygen passing layer 15 and the oxygen blocking layer 13, and the gate structure 19 arranged on the oxide semiconductor layer 17 in a region above the oxygen passing layer 15, wherein the oxide semiconductor layer 17 comprises a doping, wherein the doping, in particular a concentration of dopants, is modified in the section above the oxygen passing layer 17.

In particular, modifying the doping in the section of the oxide semiconductor layer 17 refers to removing unwanted dopants, in particular oxygen vacancies, and/or restoring electrical properties of the oxide semiconductor layer 17 that have been changed during the FET processing.

Preferably, the portion, respectively section, of the oxide semiconductor layer 17 that is arranged between the oxygen passing layer 15 and the gate structure 19, forms a channel of the FET device. The section of the oxide semiconductor layer 17 in which the doping is modified can correspond to the channel.

The "modified" section of the oxide semiconductor layer 17 can be congruent with the oxygen passing layer 15 or can extend beyond the oxygen passing layer 17.

The gate structure shown in Fig. 4 comprises the gate oxide 21, which is for instance an aluminum oxide (Al₂O₃), and the gate metal contact 21.

The structure 10 can form a portion or section of the FET device or can form the entire FET device. Preferably, the FET device is a metal-oxide-semiconductor field-effect transistor (MOSFET). The FET device can be a planar transistor, in particular a thin-film transistor (TFT), or another type of transistor, such as a FinFET.

The structure 10 may further comprise a source structure 25 and a drain structure 27, which are arranged on the oxide semiconductor layer 17 in a region above the oxygen blocking layer 15.

Preferably, the oxide semiconductor layer 17 comprises any one of the following materials: indium gallium zinc oxide, IGZO, indium tin oxide, ITO, or indium zinc oxide, IZO.

The oxygen passing layer may comprises a silicon oxide layer, a silicon oxynitride layer, a porous material layer, and/or an air gap. The oxygen passing layer 15 can form a channel for oxygen atoms below the oxide semiconductor layer 17. The oxygen atoms can penetrate the oxide semiconductor layer 17 in a section above the oxygen passing layer 15 and, thus, change the concentration of dopants, in particular oxygen vacancies, in the oxygen passing layer 15. In this way, damages in the oxide semiconductor layer 17 caused by fabrication steps of the FET processing can be eliminated and an intended doping of the passing layers 17 can be restored.

The oxygen blocking layer may comprise a metallic and/or a dielectric material layer, for example tungsten nitride, silicon nitride, aluminum oxide, titanium, titanium nitride, ruthenium, or hafnium dioxide.

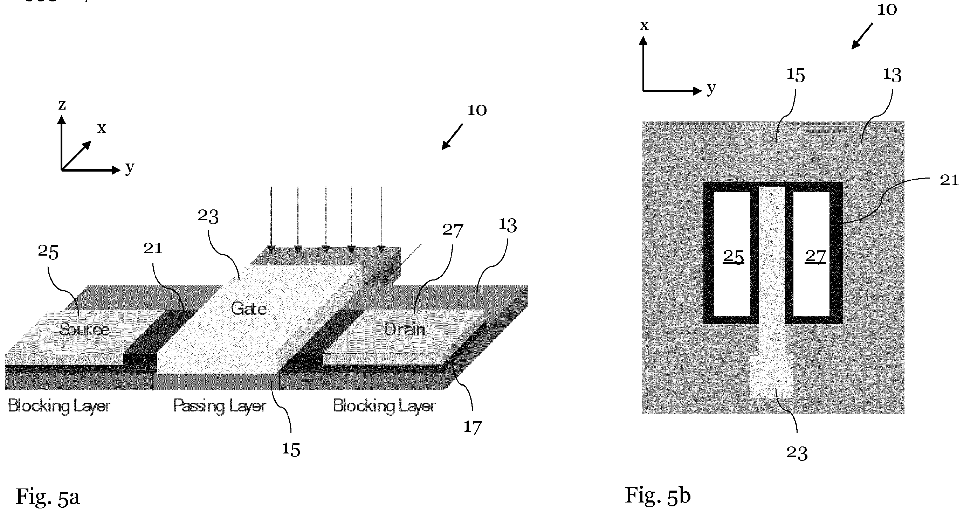

Fig 5a-b show a perspective view and a top view of a structure 10 for a FET device according to further embodiments. In particular, the structures 10 shown in Fig. 5a and 5b correspond to the structure 10 shown in Fig. 4.

In the embodiments shown in Fig. 5a and 5b, a portion of the oxygen passing layer 15 is not covered by the gate structure, which is formed by the gate oxide 21 and the gate metal contact 23.

As indicated by the arrows in Fig. 5a, oxygen can be introduced into this portion after forming the gate structure on top of the oxide semiconductor layer 17. For example, the oxygen can penetrate the oxygen passing 15 at this exposed portion and then distribute evenly throughout the oxygen passing layer and, in particular below the oxide semiconductor layer 17.

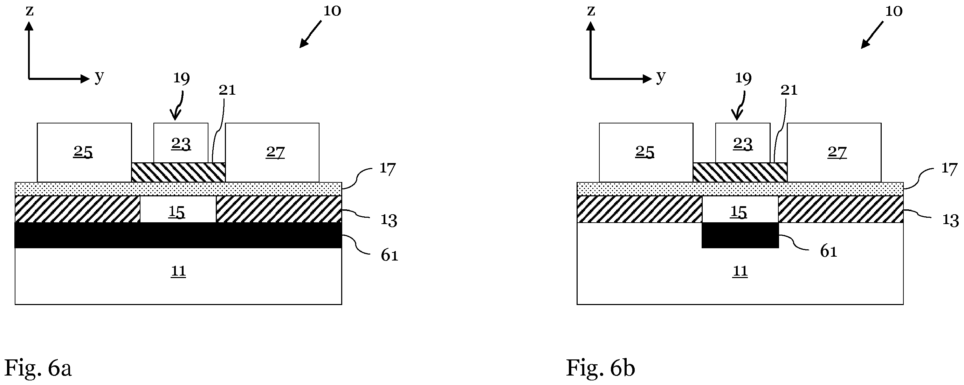

Fig. 6a-b show cross section views of two further embodiments of the structure 10 for the FET device. Both structures 10 shown in Fig. 6a and 6b comprise an additional bottom gate 61. Thereby, the oxygen passing layer 15 on top of the bottom gate 61 can act as a bottom gate dielectric layer. The bottom gate 61 can be a metallic layer on the substrate 11.

In the structure 10 depicted in Fig. 6a, the bottom gate 61 is arranged below the oxygen passing layer 15 and the oxygen blocking layer 13. This arrangement makes it easier to process the bottom gate, for example as a single material layer on the substrate 11.

The blocking layer 13 can be made of a dielectric or non-conductive material, in particular an oxide, or of a conductive material. If the blocking layer 13 is made of a dielectric or non-conductive material, the carriers can be injected into the channel from the bottom gate 61 via the oxygen passing layer 15. This carrier injection can lead to a boost of the on-current of the FET device. Preferably, no or only little injection takes place via the dielectric or non-conductive oxygen blocking layer 13. If, however, the blocking layer 13 is made of a conductive material, carriers can additionally be injected from the bottom gate 61 into the source and drain structures 25, 27 via the blocking layer 13. This can lead to an additional boost of the on-current of the FET device, wherein the bottom gate 61 can be used to control the current.

In contrast, in the structure 10 depicted in Fig. 6b, the bottom gate 61 is confined to a region below the oxygen passing layer 15. This arrangement of the bottom gate 61 requires additional processing steps, but has the advantage that the carrier injection from the bottom gate 61 is confined to the oxygen passing layer 15. Hence, the conductivity of the oxygen blocking layer 13 has less of an impact on the boost of the on-current.

Both structures 10 in Fig. 6a and 6b comprise a gate structure 19 above the channel. Leaving this top gate structure 19 intact makes the processing of the structures 10 more scalable.

Alternatively, the top gate structure 19, in particular the gate metal contact 23, can be omitted when processing the respective structures 10, to generate structures that comprise the bottom gate 61 but no top gate. This reduces the complexity of the processing of the structures 10, since no patterning of the top gate structure 19 needs to be performed. Preferably, the gate oxide 21 is formed on the oxide semiconductor layer 17 to serve as a protective layer, but the gate metal contact 23 on top of this gate oxide 21 is omitted.

## Claims

1. A method for processing a FET device, wherein the method comprises:
- providing a substrate (11);
- forming an oxygen passing layer (15) on the substrate (11);
- forming an oxygen blocking layer (13) on the substrate (11), wherein the oxygen blocking layer (13) is arranged next to the oxygen passing layer (15) and delimits the oxygen passing layer (15) on two opposite sides;
- forming an oxide semiconductor layer (17) on the oxygen passing layer (15) and the oxygen blocking layer (13);
- forming a gate structure (19) on the oxide semiconductor layer (17) in a region above the oxygen passing layer (15); and
- modifying a doping of the oxide semiconductor layer (17) by introducing oxygen into the oxygen passing layer (15), wherein at least a portion of the introduced oxygen passes through the oxygen passing layer (15) and into the oxide semiconductor layer (17).

2. The method according to claim 1, further comprising the steps:
- forming a source structure (25) on the oxide semiconductor layer (17) in a region above the oxygen blocking layer (13) on one of the two opposite sides of the oxygen blocking layer (13); and
- forming a drain structure (27) on the oxide semiconductor layer (17) in a region above the oxygen blocking layer (13) on the other one of the two opposite sides of the oxygen blocking layer (13).

3. The method according to claim 1 or 2, wherein at least the portion of the oxide semiconductor layer (17) that is arranged between the oxygen passing layer (15) and the gate structure (19) forms a channel of the FET device.

4. The method according to any one of the preceding claims, wherein the doping of the oxide semiconductor layer (17) is modified in a section above the oxygen passing layer (15), wherein the section is essentially congruent with the oxygen passing layer (15) or wherein the section extends beyond the oxygen passing layer (15).

5. The method according to any one of the preceding claims, wherein the oxygen is introduced into the oxygen passing layer (15) by means of oxygen annealing, in particular after forming the gate structure (19).

6. The method according to any one of the preceding claims, wherein a portion of the oxygen passing layer (15) is not covered by the gate structure (19).

7. The method according to any one of the preceding claims, wherein the oxide semiconductor layer (17) comprises any one of the following materials: indium gallium zinc oxide, IGZO, indium tin oxide, ITO, or indium zinc oxide, IZO.

8. The method according to any one of the preceding claims, wherein the oxygen passing layer (15) comprises a silicon oxide layer, a silicon oxynitride layer, a porous material layer, and/or an air gap.

9. The method according to any one of the preceding claims, wherein the oxygen blocking layer (13) comprises a metallic and/or a dielectric material, for example tungsten nitride, silicon nitride, aluminum oxide, titanium, titanium nitride, ruthenium, hafnium dioxide, molybdenum, titanium tungsten, silver, gold, or silicon carbonitride.

10. A structure (10) for a FET device, wherein the structure (10) comprises:
- a substrate (11);
- an oxygen passing layer (15) arranged on the substrate (11);
- an oxygen blocking layer (13) arranged on the substrate (11), wherein the oxygen blocking layer (13) is arranged next to the oxygen passing layer (15) and delimits the oxygen passing layer (15) on two opposite sides;
- an oxide semiconductor layer (17) arranged on the oxygen passing layer (15) and the oxygen blocking layer (13); and
- a gate structure (19) arranged on the oxide semiconductor layer (17) in a region above the oxygen passing layer (15);
- wherein the oxide semiconductor layer (17) comprises a doping, wherein the doping, in particular a concentration of dopants, is modified in a section above the oxygen passing layer (15).

11. The structure (10) according to claim 10, further comprising:
- a source structure (25) arranged on the oxide semiconductor layer (17) in a region above the oxygen blocking layer (13) on one of the two opposite sides of the oxygen blocking layer (13); and
- a drain structure (27) arranged on the oxide semiconductor layer (17) in a region above the oxygen blocking layer (13) on the other one of the two opposite sides of the oxygen blocking layer (13).

12. The structure (10) according to claim 10 or 11, wherein at least the portion of the oxide semiconductor layer (17) that is arranged between the oxygen passing layer (15) and the gate structure (19) forms a channel of the FET device.

13. The structure (10) according to any one of claims 10 to 12, wherein the section is congruent with the oxygen passing layer (15) or wherein the section extends beyond the oxygen passing layer (15).

14. The structure (10) according to any one of claims 10 to 13, wherein the oxide semiconductor layer (17) comprises any one of the following materials: indium gallium zinc oxide, IGZO, indium tin oxide, ITO, or indium zinc oxide, IZO.

15. The structure (10) according to any one of claims 10 to 14, wherein the oxygen passing layer (15) comprises a silicon oxide layer, a silicon oxynitride layer, a porous material layer, and/or an air gap.
